# FASCICULE DE BREVET EUROPEEN

(11) **EP 0 421 846 B1**
(45) Date de publication et mention de la délivrance du brevet: **12.01.1994**
(21) Numéro de dépôt: 90402672.1
(22) Date de dépôt: 27.09.1990
(51) Int. Cl.: H05K 7/14

(54) **Pièce de fixation multifonctionnelle**
Mehrzweckbefestigungsteil
Universal fastening device

(30) Priorité: 05.10.1989 FR 8913035
(43) Date de publication de la demande: 10.04.1991
(73) Titulaire: BULL S.A., 92800 Puteaux (FR)
(72) Inventeur: Sekouri, Omar, F-93270 Sevran (FR); Jardet, Gilles, F-91380 Chilly Mazarin (FR)
(74) Mandataire: Debay, Yves

(56) Documents cités:
- FR-A- 2 502 445
- US-A- 4 593 441
- IBM TECHNICAL DISCLOSURE BULLETIN, vol. 29, no. 5, octobre 1986, New York, US, pp. 2013-2017 ; "FLEXIBLE GUIDE FOR PRINTED CIRCUIT CARDS"
- MACHINE DESIGN, vol. 59, no. 2, 22 janvier 1987, Cleveland, US, p. 52 "MODULAR CHASSIS DESIGN CUTS SCOPE COSTS"

## Description

La présente invention concerne une pièce de fixation multifonctionnelle pour une machine informatique, telle que par exemple un micro-ordinateur.

Dans les machines informatiques ou micro-ordinateurs, il existe un besoin de fixer certains éléments constitutifs, tels qu'un haut-parleur, voyant de fonctionnement, etc. Par ailleurs, la possibilité d'installer des options dans les machines nécessite parfois l'addition de cartes électroniques additionnelles à la carte principale. Pour fixer ces éléments, la plupart du temps on utilise des systèmes à vis ou à goupilles qui nécessitent des manipulation et induisent des coûts de fabrication élevés, un tel système est connu de l'article paru dans IBM Technical Disclosure Bulletin, Vol 29, No 5, Octobre 1986, pages 2013-2017.

Un premier but de l'invention est donc de proposer une pièce de fixation multifonctionnelle qui puisse se monter de façon simple dans le châssis de la machine.

Ce but est atteint par le fait que la pièce de fixation multifonctionnelle, formée de trois surfaces, dont une surface centrale est reliée aux deux autres par des ouvertures ou découpes coopérant avec des ergots, de façon à former, après assemblage, une pièce de section en forme de U, dont les surfaces latérales sont maintenues espacées par des entretoises solidaires de chacune des surfaces latérales, une des surfaces latérales comportant des moyens de fixation sur une plaque support du châssis de la machine par des crochets coopérant avec des ouvertures, et un moyen d'encliquetage immobilisant la pièce de fixation en position.

Un mode particulier de réalisation de l'invention permet la fixation d'un haut-parleur.

Ce but est atteint par le fait que la surface centrale adjacente de la surface latérale de fixation comporte une surface tronconique et se termine par un manchon ouvert sur un côté, ledit manchon comportant des tenons de serrage du culot d'un haut-parleur.

Un autre mode particulier de réalisation de l'invention permet la fixation de moyens de signalisation.

Ce but est atteint par le fait que la surface latérale de fixation à la plaque support comporte un bossage pourvu d'ouvertures et des rainures formées sur les parois latérales internes du bossage pour accueillir une carte électronique comportant des diodes de signalisation visualisables par les ouvertures.

Un autre mode particulier de réalisation de l'invention permet le guidage de cartes électroniques.

Ce but est atteint par le fait que la surface latérale en vis-à-vis de la surface latérale de fixation comporte sur sa face externe des rainures formées par moulage.

Un autre mode particulier de réalisation de l'invention permet la fixation d'une carte de circuit imprimé.

Ce but est atteint par le fait que la surface latérale en vis-à-vis de la surface latérale de fixation comporte sur sa face interne des picots de fixation d'une carte de circuit imprimé pourvue de plages de connexion.

Un autre but de l'invention est de permettre une utilisation de la pièce multifonctionnelle pour assurer, à l'aide du châssis d'ordinateur, la fixation de cartes électroniques supplémentaires enfichables sur des connecteurs prévus sur la carte électronique principale de la machine.

Ce but est atteint par le fait que la plaque support est la plaque avant du châssis de l'ordinateur, et les rainures de la surface latérale arrière de la pièce coopérent avec des rainures pratiquées en vis-à-vis dans la face arrière du châssis de l'ordinateur.

Un dernier but de l'invention est de proposer un procédé de fabrication de la pièce de fixation.

Ce but est atteint par le fait que le procédé consiste à mouler à l'aide d'un seul moule en une seule opération les trois surfaces reliées entre elles par des bretelles, de façon à former une seule pièce ;
à plier les bretelles pour amener les ergots d'une surface en coopération avec les ouvertures et découpes de la surface adjacente, et les entretoises situées sur chacune des surfaces extrêmes en vis-à-vis ;
à encliqueter les entretoises et les ergots dans les ouvertures.

D'autres caractéristiques et avantages de la présente invention apparaîtront plus clairement à la lecture de la description ci-après, faite en référence aux dessins annexés dans lesquels :
- la figure 1 représente une vue en perspective de la pièce de fixation selon l'invention,
- la figure 2 représente une vue en perspective du châssis d'une machine permettant l'utilisation de la pièce de fixation,
- la figure 3 représente une vue de dessus de la pièce de fixation constituée par les trois éléments reliés en une seule pièce en sortie du moulage.

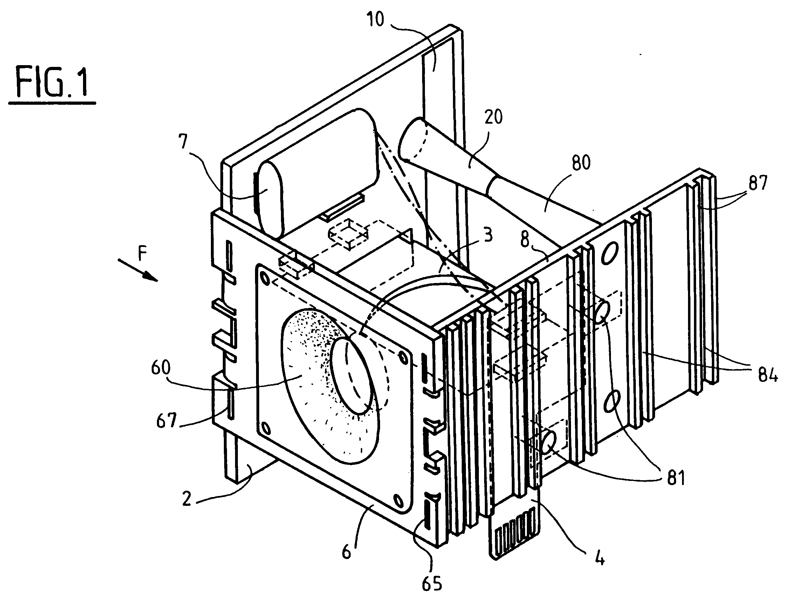

La pièce de fixation, représentée à la figure 1, une fois assemblée et prête à être accrochée sur le châssis d'une machine, comporte trois surfaces (2, 6, 8) ( dont une centrale (6) et deux latérales (2, 8) formant substantiellement un solide en forme de U. Les deux surfaces latérales (2, 8) sont maintenues écartées à l'aide d'entretoises (20, 80) solidaires chacune d'une surface respective (2, 8). Les surfaces latérales (2, 8) sont rendues solidaires de la surface centrale (6) au moyen d'un montage à l'aide d'ergots (27, 28, 85, 86) et d'ouvertures correspondantes (67, 65), et de découpes (66, 68).

Les ergots montés à l'extrémité d'une des surfaces comportent un ergot central (28, 86), entouré par deux ergots latéraux (27, 85) qui sont orientés selon des directions opposés à la direction des ergots centraux (28, 86). L'ergot (26, 86), qui coopère avec la découpe (66, 68), est orienté vers la surface centrale (6). Cette disposition permet de constituer, avec les ouvertures correspondantes (67, 65) et les découpes (66, 68), associées à l'ergot central tourné vers le bord de la découpe, un assemblage difficilement démontable des pièces (2, 6, 8). La surface centrale (6) comporte une partie tronconique (61) se terminant vers le centre par une bague (62), pourvue à sa périphérie interne, de tenons (63). La surface (6), la partie tronconique (61) et la bague (62) sont pourvus d'une fente (64) qui débouche sur le bord externe de la surface (6). Cette fente (64) permet de donner une certaine élasticité à la pièce (6) pour recevoir dans l'ouverture formée par la bague (62) le culot d'un haut-parleur (60).

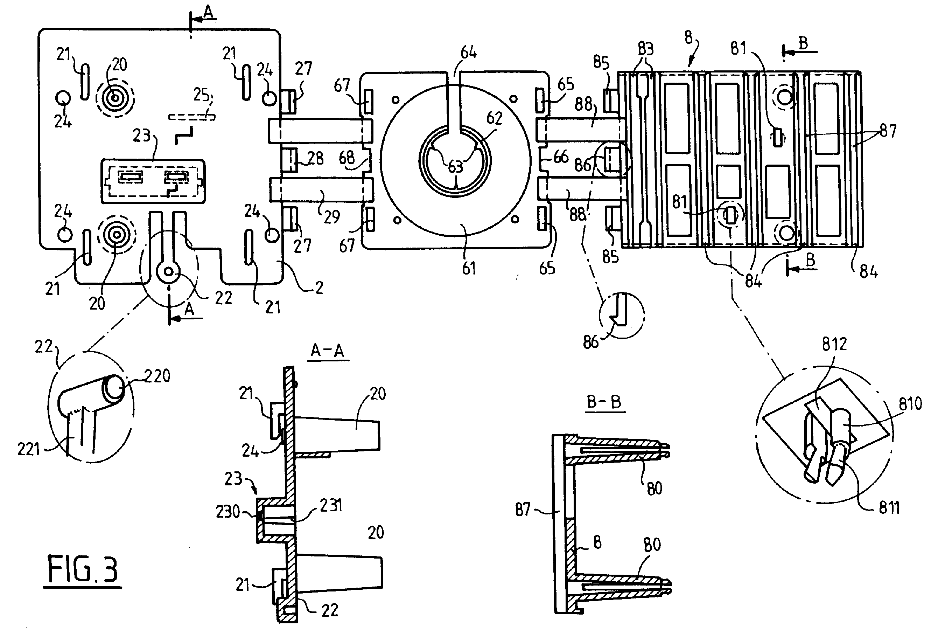

Une première surface latérale (2), dite surface latérale de fixation, comporte, comme représenté à la figure 3 et dans la bulle AA de cette figure, un ensemble de crochets (21) orientés vers l'extérieur du solide en forme de U et un bossage (23). Le bossage (23) comporte deux ouvertures (230) et sur ses deux surfaces latérales internes, deux rainures (231) qui permettent le guidage et la fixation d'une plaque de circuit imprimé (3, figure 1) supportant des diodes électroluminescentes constituant des voyants de signalisation visibles par les ouverture (23). La surface (2) comporte également une languette (221) pourvue d'un téton (220) formant un élément d'encliquetage (22). Sur la face interne de cette surface (2) sont formés deux tenons cylindriques (20) constituant des demi-entretoises pourvues à leur extrémité d'un orifice dans lequel pénètrent des tétons prévus à l'extrimité des demi-entretoises (80) situées en vis-à-vis et solidaires de la deuxième surface latérale (8) lorsque la pièce est formée en U. La deuxième surface latérale comporte, sur sa face interne, en plus des deux entretoises (80), deux tenons (81) constitués par deux demi-cylindres (810) disposés de part et d'autre d'une ouverture (812) et prolongés à leurs extrémités par des portions tronconiques (811) permettant un clipsage élastique. Ces deux tenons (81) permettent, grâce à des trous correspondants formés sur un circuit imprimé (4), la fixation du circuit imprimé (4) visible à la figure 1. Sur la face externe de la deuxième surface (8), est formée une succession de gorges (83, 84) obtenues en moulant des lèvres (87) sur cette face externe.

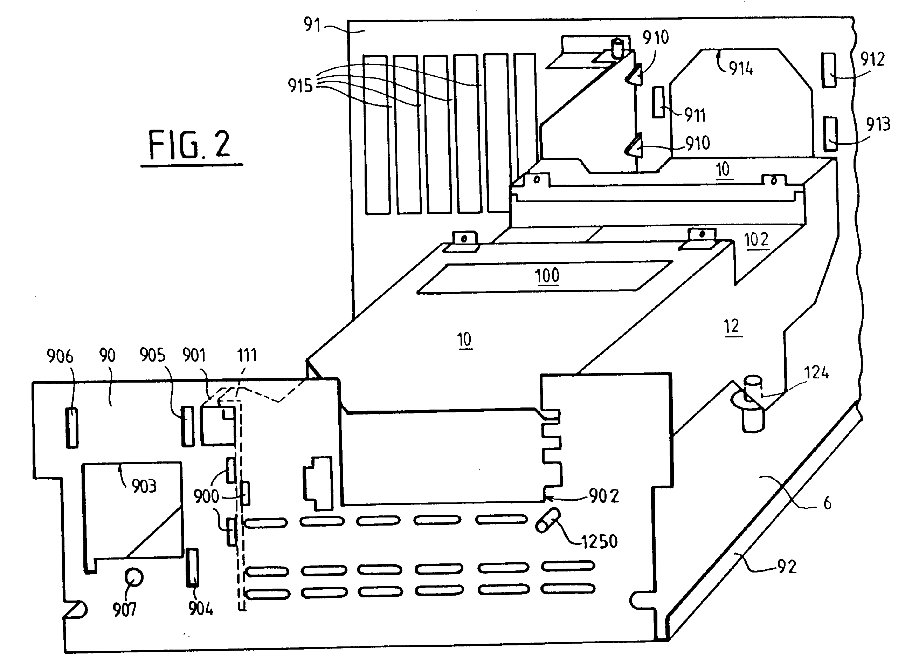

L'ensemble des trois pièces est produit dans un seul moule, et constitue en fait une pièce unique dont la surface (2) est reliée à la surface centrale (6) par des bretelles (29), tandis que la surface (6) est reliée à la deuxième surface latérale (8) par des bretelles (88). Ceci permet un moulage simple et la pièce de fixation est assemblée en pliant les bretelles (29, 88), pour ensuite introduire les ergots dans les ouvertures correspondantes sur la surface centrale. Une fois les ergots encliquetés dans les ouvertures, et les tétons des demi-entretoises (80) ancrés dans les orifices des entretoises (20), le solide en forme de U est constitué. On peut à ce moment-là introduire la carte de circuit imprimé (3) dans la rainure (231), puis la carte de circuit imprimé (4) qui vient bloquer la première (3), enfin on met en place le haut-parleur dans son logement (63), et l'ensemble ainsi équipé vient s'accrocher par les crochets (21) sur les découpes (904, 906, 905) prévues sur la face avant (90) du châssis d'une machine représentée à la figure 2. Le téton (220) vient pénétrer dans l'orifice circulaire (907) et immobilise en translation la pièce sur son support (90). L'ouverture (903) permet le passage du bossage (23) et la visualisation des états de fonctionnement de la machine. La pièce une fois fixée au support avant (90) du châssis se retrouve avec sa surface arrière (8) en vis-à-vis de la plaque arrière (91) du châssis de la machine. Cette plaque arrière (91) comporte, comme on peut le voir à la figure 2, un ensemble de gorges (915) obtenues par découpe et pliage de la tôle. Ces gorges (915) se trouvent situées en vis-à-vis des gorges correspondantes (83, 84) de la face arrière de la pièce de fixation. On a ainsi constitué des rainures de guidage de cartes électroniques additionnelles que l'on peut monter sur le châssis de la machine et connecter à des connecteurs montés sur la carte de circuit imprimé (3) constituant la carte principale de la machine.

## Revendications

1. Pièce de fixation multifonctionnelle formée de trois surfaces (2, 6, 8), dont une surface centrale (6) est reliée aux deux autres (2, 8) par des ouvertures (65, 67) et découpes (68, 66) coopérant avec des ergots (27, 28, 85, 86), de façon à former, après assemblage, une pièce de section en forme de U, dont les surfaces latérales (2, 8) sont maintenues espacées par des entretoises (20, 80) solidaires de chacune des surfaces latérales (2, 8), une des surfaces latérales (2, 8) comportant des moyens de fixation (21, 22) sur une plaque support (90), du châssis d'une machine par des crochets (21) coopérant avec des ouvertures (906, 905, 904) de la plaque support (90) et un moyen d'encliquetage (907, 22) immobilisant la pièce de fixation (2, 6, 8).

2. Pièce selon la revendication 1, caractérisée en ce que la surface centrale adjacente (6) aux deux surfaces latérales (2, 8) comporte une surface tronconique (61) se terminant par un manchon (62) ouvert sur un côté (64), et comportant des tenons (63) de serrage du culot d'un haut-parleur (60).

3. Pièce selon la revendication 1 ou 2, caractérisée en ce que la surface latérale (2) de fixation à la plaque support (90) comporte un bossage (23) pourvu d'ouvertures (230) et des rainures (231) formées sur les parois latérales internes du bossage pour accueillir une carte électronique (3) comportant des diodes de signalisation visualisables par les ouvertures (230).

4. Pièce selon une des revendications 1 à 3, caractérisée en ce que la surface latérale (8), en vis-à-vis de la surface latérale de fixation (2) comporte sur sa face interne des tétons de fixation d'une carte de circuit imprimé (4) pourvu de plages de connexions (40).

5. Pièce selon une des revendications 1 à 4, caractérisée en ce que la surface latérale (8), en vis-à-vis de la surface latérale de fixation (2), comporte sur sa face externe des rainures (83, 84) formées par moulage.

6. Utilisation de la pièce selon la revendication 5 pour assurer dans un châssis d'ordinateur la fixation de cartes électroniques supplémentaires enfichables sur des connecteurs prévus sur la carte électronique principale (3) de la machine., caractérisée en ce que la plaque support (90) est la face avant du châssis de l'ordinateur, et les rainures de la surface latérale arrière (8) de la pièce coopérent avec des rainures (915) pratiquées en vis-à-vis dans la face arrière (91) du châssis de l'ordinateur.

7. Procédé de fabrication de la pièce de fixation selon une des revendications 1 à 5, caractérisé en ce qu'il consiste :
à mouler, à l'aide d'un seul moule en une seule operation, les trois surfaces (2, 6, 8) reliées entre elles par des bretelles (29, 88), de façon à former une seule pièce ;
à plier les bretelles pour amener les ergots (27, 28, 85, 86) des surfaces latérales (2, 8) en coopération avec les ouvertures (65, 67) et découpes (66, 68) de la surface adjacente (6) et les entretoises (20, 80) situées sur chacune des surfaces latérales (2, 8) extrêmes en vis-à-vis ;
à encliqueter les ergots (85, 86, 27, 28) dans les ouvertures (67, 65, 66, 68) et les entretoises (80, 20).

## Patentansprüche

1. Multifunktionales Befestigungsteil, das aus drei Flächen (2, 6, 8) gebildet ist, wovon eine mittlere Fläche (6) mit zwei weiteren (2, 8) durch Öffnungen (65, 67) und Ausschnitte (68, 66), die mit Vorsprüngen (27, 28, 85, 86) zusammenwirken, verbunden ist, derart, daß nach dem Zusammenbau ein Teil mit U-förmigem Querschnitt gebildet ist, dessen Seitenflächen (2, 8) durch Abstandshalter (20, 80), die jeweils mit den Seitenflächen (2, 8) fest verbunden sind, in gegenseitigem Abstand gehalten werden, wobei eine der Seitenflächen (2, 8) Mittel für die Befestigung (21, 22) auf einer Trägerplatte (90) des Rahmens einer Maschine durch Haken (21), die mit Öffnungen (906, 905, 904) der Trägerplatte (90) zusammenwirken, sowie ein Einrastmittel (907, 22) aufweist, welches das Befestigungsteil (2, 6, 8) unbeweglich macht.

2. Teil gemäß Anspruch 1, dadurch gekennzeichnet, daß die an die beiden Seitenflächen (2, 8) angrenzende mittlere Fläche (6) eine kegelstumpfförmige Fläche (61) aufweist, die in einer auf einer Seite (64) geöffneten Hülse (62) endet und Zapfen (63) zum Einklemmen des Sockels eines Lautsprechers (60) aufweist.

3. Teil gemäß Anspruch 1 oder 2, dadurch gekennzeichnet, daß die Seitenfläche (2) für die Befestigung an der Trägerplatte (90) eine Ausbuchtung (23) aufweist, die mit Öffnungen (230) und in den inneren Seitenwänden der Ausbuchtung gebildeten Rillen (231) versehen ist, um eine elektronische Karte (3) aufzunehmen, die Signaldioden enthält, die durch die Öffnungen (230) beobachtet werden können.

4. Teil gemäß einem der Ansprüche 1 bis 3, dadurch gekennzeichnet, daß die der Befestigungsseitenfläche (2) gegenüberliegende Seitenfläche (8) an ihrer Innenseite Ansätze für die Befestigung einer gedruckten Leiterplatte (4), die mit Anschlußflächen (40) versehen ist, aufweist.

5. Teil gemäß einem der Ansprüche 1 bis 4, dadurch gekennzeichnet, daß die der Befestigungsseitenfläche (2) gegenüberliegende Seitenfläche (8) an ihrer Außenseite durch Formgießen gebildete Rillen (83, 84) aufweist.

6. Verwendung des Teils gemäß Anspruch 5, um im Rahmen eines Rechners die Befestigung von zusätzlichen elektronischen Karten sicherzustellen, die in Verbindungselemente einsteckbar sind, die auf der elektronischen Hauptkarte (3) der Maschine vorgesehen sind, dadurch gekennzeichnet, daß die Trägerplatte (90) die Vorderseite des Rahmens des Rechners ist und die Rillen der hinteren Seitenfläche (8) des Teils mit den Rillen (915) zusammenwirken, die gegenüber in der Rückseite (91) des Rahmens des Rechners gebildet sind.

7. Verfahren zur Herstellung des Befestigungsteils gemäß einem der Ansprüche 1 bis 5, dadurch gekennzeichnet, daß es darin besteht, daß:
mit Hilfe einer einzigen Gießform in einem einzigen Vorgang die drei Flächen (2, 6, 8) gegossen werden, die miteinander durch Riemen (29, 88) verbunden sind, um ein einziges Teil zu bilden;
die Riemen geknickt werden, um die Vorsprünge (27, 28, 85, 86) der Seitenflächen (2, 8), zum Zusammenwirken mit den Öffnungen (65, 67) und den Ausschnitten (66, 68) der angrenzenden Fläche (6), und die Abstandshalter (20, 80), die sich auf jeder der äußeren Seitenflächen (2, 8) befinden, einander gegenüber zu bringen;
die Vorsprünge (85, 86, 27, 28) in den Öffnungen (67, 65, 66, 68) und die Abstandshalter (80, 20) eingerastet werden.

## Claims

1. Multi-functional fastening component, formed of three surfaces (2, 6, 8), a central surface (6) of which is linked to the two other surfaces (2, 8) by openings (65, 67) and cut-outs (68, 66) cooperating with lugs (27, 28, 85, 86), so as to form, after assembly, a component of U-shaped section, the lateral surfaces (2, 8) of which are held apart by spacers (20, 80) forming integral parts of each of the lateral surfaces (2, 8), one of the lateral surfaces (2, 8) comprising means of fastening (21, 22) to a mounting plate (90) of the frame of a machine via hooks (21) cooperating with openings (906, 905, 904) of the mounting plate (90) and a means of snap-fitting (907, 22), immobilising the fastening component (2, 6, 8).

2. Component according to Claim 1, characterised in that the central surface (6) adjacent to the two lateral surfaces (2, 8) comprises a frusto-conical surface (61) ending in a sleeve (62), which is open on one side (64), and comprising studs (63) for gripping the base of a loudspeaker (60).

3. Component according to Claim 1 or 2, characterised in that the lateral surface (2) for fastening to the mounting plate (90) comprises a boss (23) provided with openings (230) and grooves (231) formed on the internal lateral walls of the boss in order to receive an electronic board (3) comprising signalling diodes, which are visible through the openings (230).

4. Component according to Claims 1 to 3, characterised in that the internal face of the lateral surface (8), facing the lateral fastening surface (2) comprises locating pegs for fastening a printed circuit board (4) provided with connection planes (40).

5. Component according to Claims 1 to 4, characterised in that the external face of the lateral surface (8), facing the lateral fastening surface (2), comprises grooves (83, 84) formed by moulding.

6. Use of the component according to Claim 5 in the frame of a computer in order to fasten supplementary plug-in electronic boards to connectors provided on the main electronic board (3) of the machine, characterised in that the mounting plate (90) is the front face of the frame of the computer, and the grooves of the rear lateral surface (8) of the component cooperate with grooves (915) provided facing in the rear face (91) of the frame of the computer.

7. Method of manufacturing the component according to one of Claims 1 to 5, characterised in that it consists:
of moulding, with the help of a single mould in a single operation, the three surfaces (2, 6, 8) which are linked to one another by straps (29, 88), so as to form a single component;
of folding the straps in order to bring the lugs (27, 28, 85, 86) of the lateral surfaces (2, 8) to cooperate with the openings (65, 67) and cut-outs (66, 68) of the adjacent surface (6), and to bring the spacers (20, 80) located on each of the lateral end surfaces (2, 8) to face each other;
of snap-fitting the lugs (85, 86, 27, 28) into the openings (67, 65, 66, 68) and the spacers (80, 20).
